# EUROPEAN PATENT SPECIFICATION

(11) **EP 4 298 678 B1**
(45) Date of publication and mention of the grant of the patent: **27.05.2026**
(21) Application number: 21719257.4
(22) Date of filing: 07.04.2021
(51) Int. Cl.: H10K 30/15, H10K 71/40, H10K 85/50, H10K 30/50

(54) **PRINTABLE COMPOSITION FOR OPTO-ELECTRONIC DEVICE**
DRUCKBARE ZUSAMMENSETZUNG FÜR OPTOELEKTRONISCHE VORRICHTUNG
COMPOSITION IMPRIMABLE POUR DISPOSITIF OPTOÉLECTRONIQUE

(43) Date of publication of application: 03.01.2024
(73) Proprietor: Perovskia Solar AG, 1170 Aubonne (CH)
(72) Inventor: VERMA, Anand, 1170 Aubonne (CH); MEYER, Tobias, 1173 Féchy (CH)
(74) Representative: Vesterinen, Jussi Tapio
(86) International application number: PCT/IB2021/052871
(87) International publication number: WO 2022/214848

(56) References cited:
- WO-A1-2015/127494
- US-A1- 2018 102 494
- US-A1- 2019 051 830

## Description

### Technical domain

The present invention concerns perovskite optoelectronic devices and compositions as well as methods for producing such devices.

### Related art

Based on their outstanding efficiency in converting solar energy, perovskite solar cells (PSC) have demonstrated a great potential as attractive renewable energy source over the past decade. The success story of PSCs began only in 2009 with the work of Miyasaka and coworkers, who used perovskite nanocrystals as sensitizers in a photovoltaic cell architecture known as dye-sensitized solar cells (Kojima A, et al; J. Am. Chem. Soc. 2009; 131, p. 6050 - 6051). It was demonstrated that perovskite crystals can act as light absorbing material and as electron- and hole-transporting layers in form of mesoscopic networks as well as in form of solid polycrystalline layers. Since then, several studies have confirmed the impressive performance of PSCs with reported power conversions of over 25% of solar energy.

Currently, state of the art perovskite solar cells encompass a variety of different materials and configurations, ranging from all organic to all inorganic contacts, with or without a mesoporous scaffold. Similarly, various deposition methods for the perovskite material, such as single-step, sequential, or dual-source sublimation, as well as solution and sublimation processes are being investigated.

Carbon-based monolithic PSCs are particularly suited to large scale production. Today a series of fabrication methods for these cells, including wet coating, such as spin coating, screen printing, spray coating, slot die coating, as well as evaporation techniques, such as thermal evaporation, have been applied. Individual layers of carbon-based PSC have also been fabricated by printing or coating.

Today, fabrication methods of these layered carbon-based PSCs are subject to continuous development and have given rise to several approaches in recent years, such as those described in the documents listed below.

WO2019/219951 A1 describes a method of producing layers on an electronic device by co-firing a plurality of different overlapping or superposed films comprising metal oxides, and/or carbon in addition to organic components.

WO2019/219952 A1 discloses a slot-die deposition method for layers of an electronic device. The layers comprise compact inorganic layers, mesoporous inorganic layers, a carbon layer, and a layer comprising organic-inorganic perovskite.

WO2020/147940 A1 discloses a composition comprising TiO₂ particles, which may be a mesoporous anatase and, optionally, further TiO₂ precursors. The document furthermore discloses a method of inkjet printing the TiO₂ composition on a substrate. US2019/051830 A1 discloses a perovskite thin film and method of forming a perovskite thin film. The perovskite thin film includes a substrate, a hole blocking/electron transport layer, and a sintered perovskite layer. The method of forming the perovskite solar cell includes depositing a perovskite layer onto a substrate and processing (for example, by sintering) the perovskite layer with intense pulsed light to initiate a radiative thermal response that is enabled by an alkyl halide additive. US2018/102494 A1 discloses single-layer LEDs developed using a composite thin film of organometal halide perovskite (Pero) and poly (ethylene oxide) (PEO). WO2015/127494A1 discloses a process of forming a thin film photoactive layer of a perovskite photoactive device comprising: applying at least one coating of a perovskite precursor solution and a polymer additive to a substrate.

Despite these different approaches to improve the fabrication methods of carbon-based perovskite optoelectronic devices, the manufacturing processes described in the state of the art and currently used are still quite time-consuming and uneconomical in terms of energy consumption.

In addition, the production methods known in the art provide no satisfactory solution for a rapid, precise, and cost-efficient fabrication of robust mesoporous perovskite optoelectronic devices with customizable dimension, such as Internet of Things (IoT) devices, or wearable accessories, for example in watches.

The present invention sets out to overcome these deficiencies.

### Short disclosure of the invention

An aim of the present invention is the provision of a mesoporous perovskite optoelectronic device, which can be produced at low energy expenditure, and which is robust and durable. The optoelectronic device should furthermore be capable of being manufactured in a cost- and time-efficient manner.

It is a further aim of the invention to provide a method for producing a mesoporous optoelectronic device, such as a solar cell, which is fast and versatile.

On the one hand, the fabrication method should be sufficiently fast to be suited for the fabrication of devices with large surface areas. The fabrication method should however also be sufficiently versatile and/or precise to be suited for a wide variety of optoelectronic devices, ideally the method should be readily customizable to different shapes and sizes of such devices.

According to the invention, these aims are attained by the subject-matter of the attached claims, and especially by the independent claims. Accordingly, the present invention proposes a method for producing an optoelectronic device as recited in claim 1.

Further advantageous aspects of the invention are disclosed in the dependent claims.

Both the inorganic material as well as organic precursor, which together form the perovskite crystal, are provided in the same composition and disposed onto the optoelectronic device in a single step. The function of the crystallised perovskite material is to absorb light energy and to act as an electron and/or hole transporting material.

The perovskite composition furthermore comprises polymer matrix and/or polymer matrix mixtures. Suitable polymer matrices of varied chain lengths include for example polystyrene (PS), polyethylene terephthalate (PET), polyolefin (PO), poly(vinyl alcohol) (PVA), or, preferably, poly(methyl methacrylate) (PMMA). The polymer matrix may also be a combination of two or more different polymer matrices. Preferably, said polymer matrix or a combination of polymer matrices is comprised in the perovskite composition ranging from 0.1 wt % to 50 wt %,

The function of the polymer matrix is to enhance performance and durability, as well as to stabilize the composition and structure of the optoelectronic device. Remarkably, the polymer matrix forms a protective film around the solid particles and material, including the perovskite crystals, without significantly interfering with electron or hole transport. The polymer matrix if selected with insulating property, it has a passivating and/or encapsulating effect on the material it coats. The polymer therefore provides protection for the components it covers without substantially interfering with their function. As a result, the polymer enhances the durability and robustness of the optoelectronic device without interfering with its performance. Moreover, the polymer or small molecules can be functionalized to enhance charge transport like electron conducting or hole-conducting.

During the fabrication of an optoelectronic device, the disposed layers are annealed. When the disposed perovskite composition is heated as part of this annealing step or when it is left to dry by solvent evaporation, the components of this composition penetrate into the underlying layers. This means that the perovskite material as well as the polymer matrix spreads into the underlying layers. The protective effect of the polymer matrix therefore also extends to the material and particles comprised in these layers.

With respect to what is known in the art, the invention provides the advantage that the claimed perovskite composition enables a deposition of the perovskite precursor material in one step and that the perovskite material is protected from environmental damage, such as moisture damage. As a further advantage, the claimed perovskite composition also protects materials comprised in other functional layers of the optoelectronic device, thus enhancing its robustness and durability.

Surprisingly, it was observed as part of this invention, that moisture damaged devices could be re-generated when the perovskite precursor ink comprised PMMA. This effect could also be observed when a separate PMMA composition was applied on top of the device.

The polymer matrix is therefore not only suited to prevent damage of the functional layers it penetrates but it may also at least partially repair such damages.

Preferably, the organic precursor comprised in the perovskite composition is chosen from a group of suitable organic halides known in the art. The inorganic material preferably chosen from a group of metal-halides. Together the inorganic material and the organic precursor give rise to a metal-halide perovskite crystal of the formula AMX₃, wherein A is an organic cation, M is a metal and X is a halide.

The AMX₃ crystal is formed during drying of the perovskite composition on the optoelectronic device. This can occur as part of a separate drying step in the fabrication of the layered device, or during the annealing step.

The perovskite composition furthermore comprises conductive particles. The term "conductive particles" as used herein means particles which are suitable to function as electrode material. In the optoelectronic device, the conductive particles act as a cathode and/or as a back contact. Such conductive particles may for example be carbon constituents, antimony tin oxide (ATO) constituents, Al-doped ZnO (AZO) constituents, or indium tin oxide (ITO) constituents. However, this invention is not limited to these examples and other conductive particles may be used, when comprised in the perovskite composition, the conductive particles are preferably provided ranging from 0.1 wt % to 50 wt %.

Provision of conductive particles in the perovskite composition provides the advantage that the different functions of these components, i.e. the light-harvesting properties of the perovskite material and the back electrode function of the conductive particles, are applied to the optoelectronic device in one single deposition step, as opposed to a series of subsequent depositions.

Deposition of a perovskite composition comprising perovskite precursors, carbon constituents as well as the polymer matrix together provides three functions in one step: (i) the formation of the carbon back electrode, (ii) the formation of the perovskite crystal upon drying of the perovskite composition, and (iii) the passivation and/or encapsulation of the perovskite/inorganic material by the polymer matrix.

Different from the perovskite precursor material and the polymer matrix, the conductive particles do not diffuse into the underlying layers during the fabrication of the layered optoelectronic device. The conductive particles are therefore contained in a layer, which functions as the back electrode. The conductive particles are contained in this layer regardless of whether they are disposed onto the device as part of the perovskite composition or as part of a separate electrode composition.

In a preferred embodiment, the perovskite composition can be inkjet-printed, slot-die coated, screen-printed, or blade-coated. To facilitate inkjet printing of the composition, suitable organic solvents may be chosen. The solvents are ideally complemented with a wetting agent, or surfactant. The function of the wetting agent is to disperse any particles in the composition and to prevent aggregation as well as form homogeneous films upon deposition. Aggregation of particles, such as carbon particles, in the composition may cause clogging of inkjet nozzles or other narrow or small opening through which the composition passes during the deposition step and should therefore be avoided.

The perovskite composition may however also be applied onto the device by other methods, such as, without limitation, by screen printing, slot-die coating, spin coating, gravure printing, flexo-printing, aerosol jet, spray coating, blade coating.

The composition may furthermore comprise a binding agent and/or other additives. The addition of a binding agent results in a better spatial delimitation of the layered composition. Suitable binding agents are commonly known. Preferably, the binding agent is burned out as part of the annealing step. This means that the binding agent is not comprised in the annealed layer. A suitable binding agent is for example ethyl cellulose or a cellulose derivative.

The mobilisation of the individual components of individual layers, can give rise to distinct zones in which particular components concentrate. This is for example the case for the carbon constituent for the perovskite layer, which, if contained in the perovskite composition, accumulates in the first layer. In contrast, during annealing of this first layer, the perovskite material as well as the polymer matrix contained in the perovskite composition diffuses over the other merged functional layers of the device. As a result, the perovskite material forms crystals in the merged functional layers and is not confined to the original layer as disposed.

The second composition gives rise to a second layer and the third composition gives rise to a third layer.

The third composition includes at least one metal oxide insulating material, such as ZrO₂, preferably mesoporous ZrO₂, Al₂O₃ and/or SiO₂.

Preferably, the third composition furthermore comprise a p-type semiconductor, such as a Nickel-oxide ("NiOx"), CuO, and/or CuSCN. The p-type semi-conductor acts as hole-transport material. It enhances the conductivity resulting in a faster transformation of energy of the optoelectronic device. Conventionally, the metal oxide insulating material and the p-type semiconductor are disposed in separate layers. Combining the two components in one composition enhances the efficacy in the production of the optoelectronic device, as the number of fabrication steps is reduced, and energy as well as cost is saved due to omitting the additional separate disposition and annealing steps, which are required for fabricating two separate functional layers.

It is however also possible to provide the p-type semiconductor in a separate composition in the fabrication of the optoelectronic device. The p-type semiconductor may be disposed in a separate layer.

The second composition contains at least one metal oxide semiconductor, preferably a colourless semiconductor, such as TiO₂, preferably having a band gap equal to or greater than 2.7 eV, or equal to or greater than 3 eV.

The second composition may comprise mesoporous TiO₂ as well as compact TiO₂. The provision of both, mesoporous as well as compact TiO₂ in the same composition enhances the efficiency in the fabrication of the optoelectronic device, as only one deposition and only one annealing step are required to dispose both TiO₂ structures onto the device. Habitually the different forms are disposed in separate layers, necessitating at least two deposition and annealing steps. Combining the two different structures of TiO₂ in the one composition therefore also reduces cost and enhances energy-efficiency in the fabrication of the optoelectronic device.

Similar to the perovskite composition, the second and third compositions preferably comprise suitable organic solvents, which may be complemented by surfactants, binding agents, stabilizing agent like ethanol amine, which stabilizes the compact titania precursor and prevent fast oxidation and/or other additives.

An advantage of combining mesoporous and the compact TiO₂ in one composition is that the thickness of the TiO₂ layer can be increased, this enhancing the performance of the optoelectronic device. Preferably the thickness of the TiO₂ layer ranges from 50 nanometres to 1500 nanometres, or from 300 nanometres to 800 nanometres, preferably from 450 nanometres to 550 nanometres.

However, mesoporous TiO₂ and compact TiO₂ may also be disposed separately on the optoelectronic device in consecutive steps, such as to form distinct layers.

Either of the two compositions is suited to be used in perovskite-based optoelectronic devices having layers, compositions and/or an architecture, which differ from the device and the different examples described herein.

The functional layers of the optoelectronic device, comprising the layers produced by the perovskite composition, the second composition, the third composition, and the optional electrode composition are superposed on a suitably prepared substrate. The substrate may for example be glass coated with fluorine-doped tin oxide (FTO). Laser ablation may be used to scribe the FTO coating on the substrate. Alternatively, the substrate may be a plastic, such as polymethyl methacrylate. The substrate may also be a metal like steel or a metal oxide. However, the invention is not limited to these examples and other suitable substrates, for example metals or metal-oxide semiconductors, such as ZnO, TiO₂, SnO₂, Al-doped ZnO (AZO), NiOₓ, vanadium oxide, SiO₂, Al₂O₃ Si, graphene, as well other 2D transition metal chalcogenides, such as MoS₂, MeSe₂, FeS₂, and VS₂, may be chosen.

Remarkably, the perovskite composition, as well as the second, the third composition and the optional electrode composition may all be printed onto the device in superposed layers as part of an inkjet printing process. This deposition method is particularly advantageous, if a high precision of layer deposition is desired. In addition, it is highly customizable to the different shapes of the devices, respectively the desired patterns in which the functional layers should be disposed. Furthermore, compared to other deposition procedures, inkjet printing is extremely fast, which again renders it perfectly suited for the production of small to large scale optoelectronic devices.

In addition, inkjet printing is readily adaptable to any desired shape, i.e. it is not bound to any particular shape and is therefore form-free. It can be used in combination with laser scribing for interconnects (P1, P2, P3). Alternatively, it can be set to print ink compositions only on areas on which they are required and therefore eliminating the P2 and P3 laser scribing steps.

Deposition by means of inkjet printing is fast and extremely versatile and therefore suited for a wide range of optoelectronic devices. The ability to use inkjet printing for deposition of all functional layers of the device is a distinct advantage in terms of application range, efficacy as well as cost and energy efficiency.

The optoelectronic device may furthermore comprise an encapsulant layer or film, which is disposed on top or the layered functional compositions. The device may also comprise a transparent or translucent cover plate. The purpose of the encapsulant layer and/or the cover plate is to protect the functional layers of the device from environmental influences. The encapsulant layer and/or cover plate protect the functional layer from mechanical or chemical damage due to external factors. The encapsulant, if in form of liquid adhesive or a glue, can further be coated or inkjet-printed.

Preferably, the functional layers of the optoelectronic device are superposed, such that the third layer is closest to the substrate and that the second layer is positioned between the third layer and the first layer. The electrode layer is positioned on top of the layered device, facing the light. The layers may be sandwiched between the substrate and the encapsulant film or layer, respectively the cover plate.

The invention furthermore concerns a method for producing the optoelectronic device described here above, comprising the steps of disposing a layer of the third composition comprising at least one metal oxide semiconductor, preferably a colourless semiconductor, such as TiO₂, preferably having a band gap equal to or greater than 2.7 eV, or equal to or greater than 3 eV on a suitable substrate to form a third layer, disposing the second composition comprising at least one metal oxide insulating material, such as ZrO₂, preferably mesoporous ZrO₂, Al₂O₃ and/or SiO₂ on the annealed third layer to form a second layer, disposing the perovskite composition comprising an organic precursor of a metal-halide perovskite, an inorganic material, a polymer matrix, and conductive particles on the annealed second layer to form a first layer, and, optionally, disposing an electrode composition comprising conductive particles on the annealed first layer, and annealing the disposed insulator composition.

Each layer is either be annealed individually following its deposition or co-annealed with at least one other layer in one annealing step.

Annealing of the second and/or the third layer may be performed under ambient conditions at temperatures at or below 135 degrees Celsius, or at high temperatures, at or above 300 degrees Celsius. Annealing of the first layer however must be performed at temperatures at or below 135 degrees Celsius, preferably below 115 degrees Celsius. Optionally all three functional layers, i.e. the first layer, the second layer and the third layer are each annealed at temperatures at or below 135 degrees Celsius, preferably ranging from 30 degrees Celsius to 100 degrees Celsius, or from 60 degrees Celsius to 90 degrees Celsius.

Each layer may be dried prior to annealing and/or deposition of a subsequent layer. The drying step serves to partially of fully remove solvents of the compositions from the drying layer. The individual disposed layers may each be annealed in a separate annealing step. Alternatively, superposed layers may also be co-annealed or co-fired. Co-firing of the different layer further enhances the production efficiency of the optoelectronic device. It also renders the fabrication method even more efficient in terms of time, cost, and energy expenditure.

Binding agents are generally not removed as part of a drying step. Any remaining solvents are preferably removed during the annealing procedure, which also destroys and/or removes the binding agent comprised in the layer.

Remarkably, the perovskite layer, as well as the second and third layers, i.e. the functional layers, can all be deposited by inkjet printing. The inkjet printing step may be realized by using a printing machine suitable for inkjet printing.

It is understood that various embodiments and modifications of the present embodiments and examples described herein will be obvious to those skilled in the art. To the extent that such embodiments and modifications do not depart from the scope of the claims, it is intended that they are also included in the invention disclosed herein.

### Short description of the drawings

Exemplar embodiments of the invention are disclosed in the description and illustrated by the drawings in which:
Figure 1 illustrates schematically an exemplary embodiment not according to the invention in which individual layers are superposed in the claimed perovskite optoelectronic device; and
Figure 2 depicts schematically a possible method for producing an exemplary optoelectronic device claimed in the present invention.

### Detailed description of the present invention

The invention disclosed herein combines the organic precursor of the metal-halide perovskite material, the inorganic precursor of the perovskite, a polymer matrix constituent and conductive particles in one single composition.
This composition is called the perovskite composition and is used to produce a functional layer, called the first layer, on an optoelectronic device.

The term metal-halide perovskite as used herein refers to an AMX₃ material. A is a cation group, such as methylammonium (MA), butylammonium (BA), formamidinium (FA), phenethylammonium (PEA), Caesium (Cs) or a mixture of such cation groups. M is a metal, such as Sn, Bi, Cu, Ag, preferably Pb, or a mixture of such metals. X is a halide or a combination of halides, such as Cl, Br, or, preferably, I. The absorption spectra of the metal-halide perovskite can be fine-tuned due to the nature of the halide component, respectively the ratio of the halides contained in the perovskite material. In a preferred embodiment, the metal-halide perovskite is a lead halide perovskite. However, the invention is not limited to this example.

The organic precursor of the metal-halide perovskite is an organic halide, consisting of an organic cation and a halide anion. The inorganic material of the claimed composition preferably comprises a suitable metal-halide salt.

Halide anions for organic or metal salts may be selected from a group consisting of fluoride (F⁻), chloride (CI⁻), bromide (Br⁻), iodide (I⁻).

In a one embodiment the organic precursor may be MAI and the inorganic material may comprise PbI₂. The combination of organic precursors and metal-halides used in the present invention is not particularly limited and it is obvious to the skilled person, that different combinations may be used.

The claimed perovskite composition furthermore comprises a polymer matrix, such as for example polystyrene (PS), polyethylene terephthalate (PET), polyolefin (PO), poly(vinyl alcohol) (PVA), or, preferably, poly(methyl methacrylate) (PMMA). Preferably, the polymer matrix provided in the perovskite composition ranges from 0.1 wt% to 50 wt%, preferably from 1 wt% to 10 wt%.

While the polymer matrix is comprised in the perovskite composition in the claimed invention, it is also possible that the polymer matrix is provided in a separate composition. Moreover, a separate polymer matrix composition may also be layered onto the device in addition to the claimed perovskite composition.

A suitable separate polymer matrix composition may for example comprise polymer matrix material ranging from 0.1 wt % to 50 wt%, preferably from 2 wt% to 15 wt% in one or more organic solvents.

A suitable mixture of organic solvents for a separate polymer matrix, such as a PMMA composition may for example primarily comprise terpineol and/or ethyl acetate. During the annealing step, the perovskite layer 1 is merged with its underlying layers 2 and 3. As a result, the organic metal-halide perovskite material diffuses into said underlying layers, such that it is substantially spread over the entire thickness of the merged functional layers 1, 2, 3.

In order to achieve this spreading over the superposed functional layers, the perovskite layer needs to be disposed after the other layers have been formed. This allows the polymer matrix as well as the perovskite material to penetrate the underlying layers. The perovskite material gives rise to crystals, which as a result of this diffusion span the functional layers 1, 2, 3.

The components of the claimed perovskite composition are provided in an organic solvent or a mixture of organic solvents. The solvents may be protic or aprotic, aromatic, or non-aromatic, such as aliphatic alcohols, preferably C1 to C5 aliphatic alcohols, alicyclic alcohols, such as cyclohexanol or cyclopentanol, and other organic solvents such as terpene solvents, including monoterpene alcohols, tetralin, terpineol, γ-butyrolactone (GBL), N-Methyl-2-pyrrolidone (NMP), dimethyl formamide (DMF), dimethyl sulfoxide (DMSO) and mixtures thereof.

Preferably, the claimed perovskite composition comprising a polymer matrix also contains terpineol, ethyl acetate and/or a mixture of ethyl acetate and terpineol (1:1 vol%) which enhances jetting of the ink and homogeneous layer formation.

Conductive particles are comprised in the claimed perovskite composition. Such particles may for example be antimony tin oxide (ATO) constituents, Al₂O₃-doped ZnO (AZO) constituents, or indium tin oxide (ITO) constituents, FTO constituents, or, preferably, carbon constituents. The conductive particles may be microparticles and/or nanoparticles, such as carbon black nanoparticles, nanotubes, or graphite and graphene particles, such as graphite flakes, and/or mixtures thereof.

The conductive particles may be provided in solid form or in form of an ink or a paste, comprising in suitable organic solvents. Such suitable solvents may for example comprise terpineol, xylene, GBL, aliphatic alcohols, such as ethanol, aliphatic acetates, such as ethylacetate or a combination thereof.

The perovskite / carbon composition can comprise from 40 wt% to 98 wt% of carbon. The preferred ration of carbon in the perovskite mixture is 80 wt% to 98 wt%, most preferably 95 wt%.

In one embodiment the organic solvent of the perovskite composition is a mixture including an organic solvent having a high boiling point ranging from 181 degrees Celsius to 350 degrees Celsius, such as GBL, NMP, or Terpineol, and an organic solvent having a boiling point below 181 degrees Celsius and may be selected from a group consisting of C1 to C5 aliphatic alcohol, for example ethanol, or form a group consisting of a C1 to C5 aliphatic acetates, for example ethylacetate.

A suitable solvent mixture may for example comprise terpineol combined with either GBL and ethanol, or with NMP and ethanol.

In another embodiment the organic solvent is Acetonitrile (ACN). The organic solvent may also comprise only high boiling point organic solvents like GBL or NMP. To enhance the solubility of the polymer matrix, terpineol should be contained in the solvent mixture.

In one embodiment, the composition comprises further organic components such as wetting agents, binding agents and/or other additives.

The term wetting agent as used herein means surfactant, which may or may not be volatile. The wetting agent may be added to increase spreading and levelling of the components of the composition, in particular the carbon constituent. The wetting agent makes the composition more homogenous.

The addition of a wetting agent is particularly advantageous if the perovskite composition also comprises conductive particles, such as carbon constituents. The wetting agent disperses the conductive particles, and therefore prevents an aggregation of carbon in the composition.

In addition, the wetting agent facilitates the formation of a homogenous and levelled dried layer. For this reason, the addition of a wetting agent is particularly preferable if the composition is layered onto the optoelectronic by inkjet printing, in which the printing nozzle can easily be blocked.

Suitable wetting agents are known in the art, and many are commercially available. Wetting agents may for example be alkanes, amines, fluorosurfactants, silicon-based surfactants, such as siloxanes, or hydrocarbon-based surfactants, or a combination thereof.

Binding agents are substances, which hold or draw other materials of the composition together. Binding agents enhance the cohesion and/or adhesion of the composition, both mechanically and chemically.

Preferably a suitable binding agent should be chosen or designed to disintegrate during the annealing step as part of the fabrication of the opto-electronic device. A suitable binding agent should furthermore be soluble in the organic solvents comprised in the composition to which it is added.

Organic binding agents are widely known, and include bitumens, animal and plat glues, and polymers, such as polysaccharides. Binding agents can be waxes, oils, such as linseed oil, gums, and proteins, such as egg white or casein. In a preferred embodiment the binding agent is cellulose or a cellulose derivative, such as ethyl cellulose.

In the example presented herein, the functional layers comprise at least one TiO₂ layer, which is the third layer 3, and an insulant layer, which is the second layer 2.

In a preferred embodiment, the third layer 3 is produced using a third composition containing compact TiO₂ as well as mesoporous TiO₂. The third composition may be prepared by mixing separate compositions, one of which contains compact TiO₂ precursor and another one contains mesoporous TiO₂.

A compact TiO₂ composition may for example be prepared with an organic titanate precursor, such as titaniumisopropoxid bis(acetylacetonate) dissolved in suitable organic solvents, such as a combination of terpineol, xylene, ethylacetate, acetonitrile. The composition may however also be prepared on the basis of other organic solvents such as isopropanol, ethanol, tetralin, decalin, ethylacetate, and others. Preferably a suitable surfactant, such as a fluorosurfactant, for example Zonyl-FS 300, HFE 7500, or a siloxane surfactant is added to the composition. The ink is stabilized by addition of stabilizers like amines, such as ethanol amine.

A mesoporous TiO₂ composition may for example be prepared using Titania oxide nanoparticles, which are contained in a suitable organic solvent, preferably at 1 wt% to 25 wt%. A suitable organic solvent may for example be a combination of terpineol, isopropanol and ethanol, preferably in equal volumes. However, mesoporous TiO₂ may also be prepared in other organic solvents. Preferably, the composition comprises a binder, such as ethyl cellulose, polystyrene or PMMA and, optionally, a surfactant.

The addition of a surfactant, also referred to as wetting agent, is particularly desirable for compositions which are disposed onto the device by inkjet printing.

In a preferred aspect of the described embodiment the third composition is prepared by combining the mesoporous TiO₂ composition and the compact TiO₂ composition described above at a suitable ratio. A suitable ratio may for example be 1 volume of the compact TiO₂ composition and 9 volumes of the mesoporous TiO₂ composition. However, the invention is not limited to this particular ratio and other ratios are possible.

The combined compact/mesoporous TiO₂ composition may also be combined in different ways. Different precursors for compact TiO₂ and for mesoporous TiO₂ are known in the art and may be used. The precursors of the different structures may also be mixed directly into a combined compact/mesoporous TiO₂ composition.

Whilst the different structures of the TiO₂, i.e. the compact and mesoporous forms, may be provided in the same second composition, the structures will largely separate from each other as part of the annealing step and each concentrate in separate zones within the third layer.

However, it is also possible, that the compositions comprising either compact TiO₂ or mesoporous TiO₂ are layered onto the optoelectronic device in separate, subsequent deposition steps, as known in the art.

In a preferred embodiment, the second layer 2 is produced using a second composition comprising mesoporous ZrO₂ doped with compact NiOx and/or mesoporous NiOx.

In one aspect of this embodiment the second composition is prepared by combining a ZrO₂ composition containing mesoporous ZrO₂ with a NiOx composition containing compact NiOx and/or mesoporous NiOx. The second composition may however also be prepared in other ways, for example by mixing suitable precursors for ZrO₂ and NiOx directly in the same composition.

A ZrO₂ composition may for example be a zirconia ink, comprising zirconia nanoparticles ranging from 0.1 wt% to 50 wt%, preferable from 1 wt% to 5 wt%, ideally 3 wt% dissolved in suitable organic solvent, such as for example an equal volume mixture of terpineol, ethanol and xylene. Preferably, the composition furthermore comprises a suitable binder, such as such as ethyl cellulose, polystyrene or PMMA and, optionally, a surfactant.

The second composition may then be prepared by mixing compact and mesoporous NiOx precursor sol-gel, respectively a paste, or NiOx particles with the ZrO₂ composition. NiOx may be added to make up 0.1 wt% to 20 wt% of the second composition.

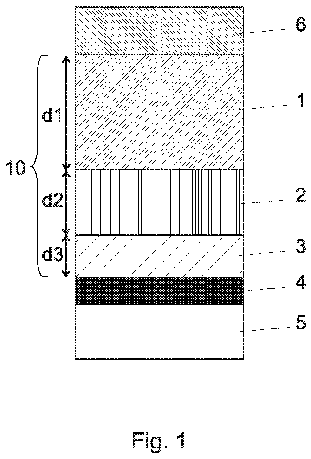

In the embodiment shown in Figure 1, the functional layers comprise the TiO₂ third layer 3 which contains mesoporous as well as compact TiO₂, and the insulant second layer 2, comprising mesoporous ZrO₂ doped with a mixture of mesoporous and compact NiOx. It should however be noted that the functional layers of the metal halide perovskite optoelectronic device may comprise different suitable compositions and may include further layers comprising individual components of the described functional layers. The number of functional layers is not limited, and neither is the exact order of the layers.

The metal-halide perovskite is provided in a composition together with conductive particles, such as carbon particles. The perovskite composition 1 is disposed on top of the other functional layers 2, 3. The metal-halide perovskite diffuses throughout the merged layers 1, 2, 3 in the annealing step, as mentioned above, while the conductive particles substantially concentrate in a layered zone on top of the second 2 and the third 3 functional layers. This zone functions as a back electrode of the optoelectronic device.

The polymer matrix, regardless of whether it is provided with the perovskite composition as part of a separate composition, also diffuses into the merged layers.

Figure 1 shows a schematic representation of a possible embodiment depicting different layers of an annealed optoelectronic device. Even though the metal-halide perovskite precursors are only contained in the perovskite composition, which is disposed after the third layer 3 and the second layer 2 as claimed herein have been formed on the device, the perovskite material 10 diffuses into the second layer 2 and the third layer 3 once the perovskite layer 1 has been disposed. In the finished device perovskite material 10 is therefore present in the first layer 1, in the second layer 2 and in the third layer 3.

In the embodiment shown in Figure 1, which is not according to the invention, the conductive particles are not comprised in the perovskite composition. Instead, the conductive particles are disposed as part of an electrode composition forming the electrode layer 6.

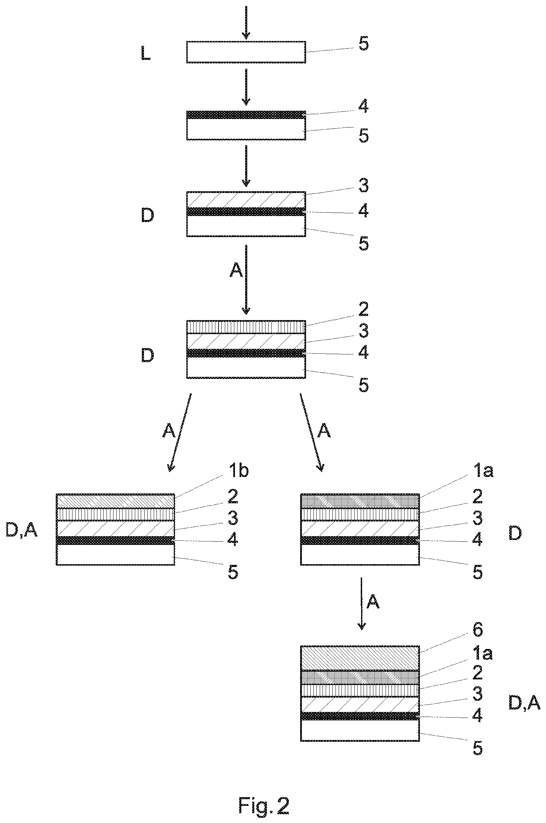

In the non-inventive example shown in Figures 1, which may be prepared using one of the alternative methods shown in Figure 2, the different ink compositions were disposed onto a substrate 5 coated with FTO 4 in successive order, whereby each layer was annealed on the device after its deposition. Optionally, a disposed layer may be dried before being annealed. It is also possible that several layers are cofired or co-annealed at the same time.

The third composition comprising a mixture of compact and mesoporous TiO₂, as described above, was used to produce the third layer 3 on the FTO-coated substrate. Preferably, the FTO film is laser scribed L onto the substrate 5. As indicated in Figure 2 the disposed composition is annealed A prior to a subsequent deposition step D, in which the second composition comprising mesoporous ZrO₂ and mesoporous as well as compact NiOx is layered onto the device and annealed to give rise to the second layer 2. As schematically shown in Figure 1, typically, the compact and mesoporous TiO₂ layer 3 has a thickness d3 of 50 nanometres to 1500 nanometres, for example between 540 nanometres and 560 nanometres. The second layer generally has a thickness d2 ranging from 50 nanometres to 5000 nanometres, for example from 1450 nanometres to 1550 nanometres. The first layer has preferably a thickness d1 ranging from 5 micrometres to 25 micrometres.

The third layer 3 of the example described herein can be annealed at high temperatures, for example upon exposure to 500 ± 5 degrees Celsius for 1 hour. Alternatively, the third layer 3 can be annealed at ambient condition, for example at 70 ± 5 degrees Celsius for 10 minutes.

The second layer 2 of the example described herein may be annealed at high temperatures, for example upon exposure to 400 ± 5 degrees Celsius for 1 hour. The second layer 2 can however also be annealed at ambient condition, for example at 90 ± 5 degrees Celsius for 10 minutes.

Once the third layer 3 and the second layer 2 as described herein of the device have been formed, the perovskite composition can be applied. It should be noted that the composition of the second and third layers are not limited by the example shown in Figure 1. The second and third compositions forming said layers may comprise different components or structures of components. The second composition and the third composition used in the process of fabricating the layered optoelectronic device are only limited by the claims. The subsequent steps of producing the carbon perovskite layer may therefore be performed on any device comprising the superposed layers of the second and the third composition as claimed.

Different ways to produce the perovskite crystal and the layered conductive constituents on the optoelectronic device are possible.

In a preferred embodiment, a perovskite composition comprising the organic perovskite precursor, the inorganic material, the polymer matrix as well as the conductive particles is layered onto the second layer 2 and annealed A at ambient temperatures, for example at a temperature ranging from 30 degrees Celsius to 135 degrees Celsius, preferably 70 ± 5 degrees Celsius for 10 minutes ±3 minutes. Resulting from this, the first layer 1b is formed, which comprises the conductive particles, perovskite material and the polymer matrix, wherein the perovskite material and the polymer matrix diffuse into layers 2 and 3 during the annealing step.

In an optional subsequent step, a polymer matrix composition, for example a PMMA composition, may be disposed D onto this first layer 1b (not shown). The PMMA composition will at least partially penetrate the underlying layers, providing a protective coating of the material, in particular the perovskite crystal formed in these layers. A part of the insulant composition may solidify in form of a protective insulant layer 6 on top of the device.

The deposition of a polymer matrix composition onto a perovskite optoelectronic device is also advantageous for the fabrication of devices which do not comprise a composition, which gives rise to a functional layer and includes a polymer matrix.

In a further embodiment not according to the invention, the perovskite composition does not contain the conductive particles for the back electrode. The perovskite composition is disposed D and annealed A on the device in this perovskite composition to form the first layer 1a. In this embodiment, the conductive particles are disposed onto the perovskite layer in a separate deposition step D to form the electrode layer 6. The perovskite layer 1a may be annealed prior deposition of the electrode composition. Alternatively, the electrode deposition may also be disposed on the unannealed perovskite layer 1a. The annealing A conditions for the perovskite layer 1a are the same as for the previous example.

In an example, which is not shown, the composition comprising the metal-halide perovskite precursor and the conductive particles is disposed onto the layers 2 and 3. The composition comprising the metal halide perovskite precursor and the conductive particles, but not the organic precursor, can be annealed on the device at high temperatures, for example at 200-400 degrees Celsius for 1 hour +- 30 minutes, or at ambient temperatures, for example at 90 ± 5 degrees Celsius for 10 minutes ± 3 minutes.

In a subsequent step of this possible non-inventive example, a perovskite composition containing the organic perovskite precursor and, optionally, also a metal-halide perovskite salt, may be layered onto the electrode layer and annealed at ambient temperatures, preferably at a temperature ranging from 30 degrees Celsius to 130 degrees Celsius, preferably 70 ± 5 degrees Celsius for 10 minutes ± 3 minutes. The perovskite material comprised in the resulting layer will diffuse into the underlying functional layers, specifically into the carbon layer, the second layer 2, and the third layer 3 during the annealing step. Optionally, the organic perovskite precursor composition may also comprise a polymer matrix, such as PMMA.

Preferably, each of the functional layers is disposed on the device by an inkjet printing process. However, depending on the specific composition and physical parameters, deposition equipment available and/or requirements of the device, such as its size, different deposition methods may be chosen for each individual layer.

Optionally, the optoelectronic device may be sealed with a transparent or translucent encapsulant layer or film (not shown in the depicted example). The encapsulant serves to protect the functional layers from adverse environmental conditions and influences.

In addition, a transparent or translucent cover plate may be positioned on the layers of the device.

## Claims

1. A method for producing an optoelectronic device comprising the steps of:
a. disposing a layer of a third composition comprising at least one metal oxide semiconductor, on a suitable substrate to form a third layer (3),
b. disposing a layer of a second composition comprising at least one metal oxide insulating material on the third layer (3) to form a second layer (2),
c. disposing a layer of a first, perovskite composition comprising an organic precursor of a metal-halide perovskite material, an inorganic material, a polymer matrix material, at least one organic solvent, and conductive particles on the second layer (2) to form a first layer (1), the perovskite composition giving rise to perovskite material, and
wherein each layer is either annealed individually following its deposition or wherein at least two layers are co-annealed in an annealing step, wherein the layers are merged, the perovskite material and the polymer matrix material of the first layer are diffused into the second and third layers (2, 3), and the perovskite material forms crystals in the first, second and third layers (1, 2, 3), wherein the polymer matrix material forms a protective film around the crystals, and wherein the conductive particles concentrate in a layered zone on top of the second and third layers (2, 3) thereby forming a back electrode of the optoelectronic device.

2. The method according to claim 1, wherein the metal oxide insulating material is ZrO₂, preferably mesoporous ZrO₂, Al₂O₃ and/or SiO₂, and the metal oxide semiconductor is a colourless semiconductor, such as TiO₂, preferably having a band gap equal to or greater than 2.7 eV, or equal to or greater than 3 eV.

3. The method according to claim 1 or 2, wherein the polymer matrix material comprises one or more polymers selected from a group of polystyrene (PS), polyethylene terephthalate (PET), polyolefin (PO), poly(vinyl alcohol) (PVA), or, preferably, poly(methyl methacrylate) (PMMA), wherein the content of said polymer matrix comprised in the perovskite composition preferably ranges from 0.1 wt % to 50 wt %.

4. The method according to any one of the preceding claims, wherein the organic precursor is an organic halide salt, such as a methylammonium halide, a formamidinium halide, a butylammonium halide, a guanidinium halide, or a phenethylammonium halide, preferably methylammonium iodide (MAI).

5. The method according to any one of the preceding claims, wherein the inorganic material is a metal-halide, for example tin halide or a lead halide, preferably lead iodide (PbI₂).

6. The method according to any one of the preceding claims, wherein the conductive particles are suitable to function as electrode material, and are for example, carbon constituents, antimony tin oxide (ATO) constituents, antimony-doped ZnO (AZO) constituents, or indium tin oxide (ITO), preferably provided at 40 wt % to 98 wt %, most preferably at 95wt %.

7. The method according to any one of the preceding claims, wherein the at least one organic solvent is
- acetonitrile (ACN) and/or a high boiling point solvent having a boiling point from 181 degrees Celcius to 350 degrees Celsius, such as γ-Butyrolactone (GBL), N-Methyl-2-pyrrolidone (NMP), or Terpineol, or
- a mixture of ACN or a high boiling point solvent having a boiling point from 181 degrees Celsius to 350 degrees Celsius and an organic solvent having a boiling point below 181 degrees Celsius, which may be an aliphatic alcohol, an aliphatic acetate and/or xylene.

8. The method according to any one of the preceding claims, wherein the second composition further comprises a p-type semiconductor, such as a nickel oxide, preferably NiO or NiO₂.

9. The method according to any one of the preceding claims, wherein the third composition comprises mesoporous as well as compact TiO₂, preferably at a ratio of 9:1 vol%.

10. The method according to any one of the preceding claims, wherein the device further comprises a substrate (5), which is preferably coated with a conductive layer (4), such as fluorine-doped tin oxide (FTO), and, optionally, an encapsulant layer, for example comprising an encapsulant glue, disposed on the light-harvesting surface of the optoelectronic device.

11. The method according to any one of the preceding claims, wherein the device comprises a substrate (5), on which the first layer (1), the second layer (2), the third layer (3) and, optionally, an electrode layer (6) are at least partially disposed, such that the third layer (3) is closest to the substrate (5), the second layer (2) is positioned between the third layer (3) and the first layer (1) and the optional electrode layer (6) is positioned on top of the first layer (1).

12. The method according to any one of the preceding claims, wherein the method further comprises the step disposing a layer of an electrode composition comprising conductive particles on the annealed first layer (1).

13. The method according to any one of the preceding claims, wherein annealing of at least the first layer is performed at temperatures at or below 115 degrees Celsius, preferably ranging from 30 degrees Celsius to 100 degrees Celsius, more preferably ranging from 60 degrees Celsius to 90 degrees Celsius for a period of less than 60 minutes, or of less than 15 minutes, preferably for a period of 8 minutes to 12 minutes.

14. The method according to any one of the preceding claims, wherein the perovskite composition, the second composition and/or the third composition are inkjet-printed.

## Patentansprüche

1. Verfahren zur Herstellung einer optoelektronischen Vorrichtung, umfassend die Schritte:
a. Aufbringen einer Schicht einer dritten Zusammensetzung, die mindestens einen Metalloxid-Halbleiter umfasst, auf ein geeignetes Substrat, um eine dritte Schicht (3) zu bilden,
b. Aufbringen einer Schicht einer zweiten Zusammensetzung, die mindestens ein Metalloxid-Isoliermaterial umfasst, auf die dritte Schicht (3), um eine zweite Schicht (2) zu bilden,
c. Aufbringen einer Schicht einer ersten Perowskit-Zusammensetzung, die einen organischen Vorläufer eines Metallhalogenid-Perowskit-Materials, ein anorganisches Material, ein Polymermatrixmaterial, mindestens ein organisches Lösungsmittel und leitfähige Partikel umfasst, auf die zweite Schicht (2), um eine erste Schicht (1) zu bilden, wobei die Perowskit-Zusammensetzung zur Bildung von Perowskit-Material führt, und
wobei jede Schicht entweder individuell nach ihrem Aufbringen getempert wird oder wobei mindestens zwei Schichten in einem Temperschritt gemeinsam getempert werden, wobei die Schichten zusammengeführt werden, das Perowskit-Material und das Polymermatrixmaterial der ersten Schicht in die zweite und dritte Schicht (2, 3) diffundieren und das Perowskit-Material Kristalle in der ersten, zweiten und dritten Schicht (1, 2, 3) bildet, wobei das Polymermatrixmaterial einen Schutzfilm um die Kristalle bildet, und wobei die leitfähigen Partikel sich in einer geschichteten Zone auf der zweiten und dritten Schicht (2, 3) konzentrieren, wodurch eine Rückelektrode der optoelektronischen Vorrichtung gebildet wird.

2. Verfahren nach Anspruch 1, wobei das Metalloxid-Isoliermaterial ZrO₂, vorzugsweise mesoporöses ZrO₂, Al₂O₃ und/oder SiO₂ ist und der Metalloxid-Halbleiter ein farbloser Halbleiter, wie etwa TiO₂, ist, der vorzugsweise eine Bandlücke gleich oder größer als 2,7 eV oder gleich oder größer als 3 eV aufweist.

3. Verfahren nach Anspruch 1 oder 2, wobei das Polymermatrixmaterial ein oder mehrere Polymere umfasst, ausgewählt aus einer Gruppe von Polystyrol (PS), Polyethylenterephthalat (PET), Polyolefin (PO), Polyvinylalkohol (PVA) oder vorzugsweise Polymethylmethacrylat (PMMA), wobei der Gehalt des in der Perowskit-Zusammensetzung enthaltenen Polymermatrixmaterials vorzugsweise im Bereich von 0,1 Gew.-% bis 50 Gew.-% liegt.

4. Verfahren nach einem der vorhergehenden Ansprüche, wobei der organische Vorläufer ein organisches Halogenidsalz ist, wie etwa ein Methylammoniumhalogenid, ein Formamidiniumhalogenid, ein Butylammoniumhalogenid, ein Guanidiniumhalogenid oder ein Phenethylammoniumhalogenid, vorzugsweise Methylammoniumiodid (MAI).

5. Verfahren nach einem der vorhergehenden Ansprüche, wobei das anorganische Material ein Metallhalogenid ist, beispielsweise Zinnhalogenid oder ein Bleihalogenid, vorzugsweise Bleiiodid (PbI₂).

6. Verfahren nach einem der vorhergehenden Ansprüche, wobei die leitfähigen Partikel geeignet sind, als Elektrodenmaterial zu fungieren, und beispielsweise Kohlenstoffbestandteile, Antimonzinnoxid (ATO)-Bestandteile, Antimon-dotierte ZnO (AZO)-Bestandteile oder Indiumzinnoxid (ITO) sind, vorzugsweise bereitgestellt zu 40 Gew.-% bis 98 Gew.-%, am meisten bevorzugt zu 95 Gew.-%.

7. Verfahren nach einem der vorhergehenden Ansprüche, wobei das mindestens eine organische Lösungsmittel
- Acetonitril (ACN) und/oder ein hochsiedendes Lösungsmittel mit einem Siedepunkt von 181 Grad Celsius bis 350 Grad Celsius ist, wie etwa γ-Butyrolacton (GBL), N-Methyl-2-pyrrolidon (NMP) oder Terpineol, oder
- ein Gemisch aus ACN oder einem hochsiedenden Lösungsmittel mit einem Siedepunkt von 181 Grad Celsius bis 350 Grad Celsius und einem organischen Lösungsmittel mit einem Siedepunkt unter 181 Grad Celsius ist, das ein aliphatischer Alkohol, ein aliphatisches Acetat und/oder Xylol sein kann.

8. Verfahren nach einem der vorhergehenden Ansprüche, wobei die zweite Zusammensetzung ferner einen p-Typ-Halbleiter umfasst, wie etwa ein Nickeloxid, vorzugsweise NiO oder NiO₂.

9. Verfahren nach einem der vorhergehenden Ansprüche, wobei die dritte Zusammensetzung sowohl mesoporöses als auch kompaktes TiO₂ umfasst, vorzugsweise in einem Verhältnis von 9:1 Vol.-%.

10. Verfahren nach einem der vorhergehenden Ansprüche, wobei die Vorrichtung ferner ein Substrat (5) umfasst, das vorzugsweise mit einer leitfähigen Schicht (4), wie etwa Fluordotiertem Zinnoxid (FTO), beschichtet ist, und gegebenenfalls eine Verkapselungsschicht, die beispielsweise einen Verkapselungsklebstoff umfasst, die auf der Lichtsammelfläche der optoelektronischen Vorrichtung angeordnet ist.

11. Verfahren nach einem der vorhergehenden Ansprüche, wobei die Vorrichtung ein Substrat (5) umfasst, auf dem die erste Schicht (1), die zweite Schicht (2), die dritte Schicht (3) und gegebenenfalls eine Elektrodenschicht (6) zumindest teilweise so angeordnet sind, dass die dritte Schicht (3) dem Substrat (5) am nächsten ist, die zweite Schicht (2) zwischen der dritten Schicht (3) und der ersten Schicht (1) positioniert ist und die optionale Elektrodenschicht (6) oben auf der ersten Schicht (1) positioniert ist.

12. Verfahren nach einem der vorhergehenden Ansprüche, wobei das Verfahren ferner den Schritt des Aufbringens einer Schicht einer Elektrodenzusammensetzung, die leitfähige Partikel umfasst, auf die getemperte erste Schicht (1) umfasst.

13. Verfahren nach einem der vorhergehenden Ansprüche, wobei das Tempern zumindest der ersten Schicht bei Temperaturen bei oder unter 115 Grad Celsius, vorzugsweise im Bereich von 30 Grad Celsius bis 100 Grad Celsius, weiter bevorzugt im Bereich von 60 Grad Celsius bis 90 Grad Celsius für einen Zeitraum von weniger als 60 Minuten oder von weniger als 15 Minuten, vorzugsweise für einen Zeitraum von 8 Minuten bis 12 Minuten, durchgeführt wird.

14. Verfahren nach einem der vorhergehenden Ansprüche, wobei die Perowskit-Zusammensetzung, die zweite Zusammensetzung und/oder die dritte Zusammensetzung mittels Tintenstrahldruck gedruckt werden.

## Revendications

1. Procédé de production d'un dispositif optoélectronique comprenant les étapes consistant à :
a. disposer une couche d'une troisième composition comprenant au moins un semi-conducteur à oxyde métallique sur un substrat approprié pour former une troisième couche (3),
b. disposer une couche d'une deuxième composition comprenant au moins un matériau isolant à oxyde métallique sur la troisième couche (3) pour former une deuxième couche (2),
c. disposer une couche d'une première composition de pérovskite comprenant un précurseur organique d'un matériau pérovskite aux halogénures métalliques, un matériau inorganique, un matériau de matrice polymère, au moins un solvant organique et des particules conductrices sur la deuxième couche (2) pour former une première couche (1), la composition de pérovskite donnant lieu à un matériau pérovskite, et
dans lequel chaque couche est soit recuite individuellement après son dépôt, soit dans lequel au moins deux couches sont co-recuites dans une étape de recuit, dans lequel les couches sont fusionnées, le matériau pérovskite et le matériau de matrice polymère de la première couche sont diffusés dans les deuxième et troisième couches (2, 3), et le matériau pérovskite forme des cristaux dans les première, deuxième et troisième couches (1, 2, 3), dans lequel le matériau de matrice polymère forme un film protecteur autour des cristaux, et dans lequel les particules conductrices se concentrent dans une zone stratifiée au-dessus des deuxième et troisième couches (2, 3), formant ainsi une électrode arrière du dispositif optoélectronique.

2. Procédé selon la revendication 1, dans lequel le matériau isolant à oxyde métallique est le ZrO₂, de préférence le ZrO₂ mésoporeux, l'Al₂O₃ et/ou le SiO₂, et le semi-conducteur à oxyde métallique est un semi-conducteur incolore, tel que le TiO₂, ayant de préférence une bande interdite égale ou supérieure à 2,7 eV, ou égale ou supérieure à 3 eV.

3. Procédé selon la revendication 1 ou 2, dans lequel le matériau de matrice polymère comprend un ou plusieurs polymères choisis dans un groupe constitué par le polystyrène (PS), le polyéthylène téréphtalate (PET), la polyoléfine (PO), le poly(alcool vinylique) (PVA), ou, de préférence, le poly(méthacrylate de méthyle) (PMMA), dans lequel la teneur dudit matériau de matrice polymère compris dans la composition de pérovskite varie de préférence de 0,1 % en poids à 50 % en poids.

4. Procédé selon l'une quelconque des revendications précédentes, dans lequel le précurseur organique est un sel d'halogénure organique, tel qu'un halogénure de méthylammonium, un halogénure de formamidinium, un halogénure de butylammonium, un halogénure de guanidinium ou un halogénure de phénéthylammonium, de préférence l'iodure de méthylammonium (MAI).

5. Procédé selon l'une quelconque des revendications précédentes, dans lequel le matériau inorganique est un halogénure métallique, par exemple un halogénure d'étain ou un halogénure de plomb, de préférence l'iodure de plomb (PbI₂).

6. Procédé selon l'une quelconque des revendications précédentes, dans lequel les particules conductrices sont appropriées pour fonctionner comme matériau d'électrode, et sont par exemple des constituants de carbone, des constituants d'oxyde d'étain et d'antimoine (ATO), des constituants de ZnO dopé à l'antimoine (AZO), ou de l'oxyde d'indium-étain (ITO), fournis de préférence à raison de 40 % en poids à 98 % en poids, et de manière tout particulièrement préférée à 95 % en poids.

7. Procédé selon l'une quelconque des revendications précédentes, dans lequel l'au moins un solvant organique est
- l'acétonitrile (ACN) et/ou un solvant à point d'ébullition élevé ayant un point d'ébullition de 181 degrés Celsius à 350 degrés Celsius, tel que la γ-butyrolactone (GBL), la N-méthyl-2-pyrrolidone (NMP) ou le terpinéol, ou
- un mélange d'ACN ou d'un solvant à point d'ébullition élevé ayant un point d'ébullition de 181 degrés Celsius à 350 degrés Celsius et d'un solvant organique ayant un point d'ébullition inférieur à 181 degrés Celsius, qui peut être un alcool aliphatique, un acétate aliphatique et/ou du xylène.

8. Procédé selon l'une quelconque des revendications précédentes, dans lequel la deuxième composition comprend en outre un semi-conducteur de type p, tel qu'un oxyde de nickel, de préférence le NiO ou le NiO₂.

9. Procédé selon l'une quelconque des revendications précédentes, dans lequel la troisième composition comprend du TiO₂ mésoporeux ainsi que du TiO₂ compact, de préférence selon un rapport de 9 : 1 % en volume.

10. Procédé selon l'une quelconque des revendications précédentes, dans lequel le dispositif comprend en outre un substrat (5), qui est de préférence revêtu d'une couche conductrice (4), telle que de l'oxyde d'étain dopé au fluor (FTO), et, éventuellement, une couche d'encapsulation, comprenant par exemple une colle d'encapsulation, disposée sur la surface de collecte de lumière du dispositif optoélectronique.

11. Procédé selon l'une quelconque des revendications précédentes, dans lequel le dispositif comprend un substrat (5), sur lequel la première couche (1), la deuxième couche (2), la troisième couche (3) et, éventuellement, une couche d'électrode (6) sont au moins partiellement disposées, de telle sorte que la troisième couche (3) est la plus proche du substrat (5), la deuxième couche (2) est positionnée entre la troisième couche (3) et la première couche (1) et la couche d'électrode optionnelle (6) est positionnée au-dessus de la première couche (1).

12. Procédé selon l'une quelconque des revendications précédentes, dans lequel le procédé comprend en outre l'étape consistant à disposer une couche d'une composition d'électrode comprenant des particules conductrices sur la première couche (1) recuite.

13. Procédé selon l'une quelconque des revendications précédentes, dans lequel le recuit d'au moins la première couche est effectué à des températures égales ou inférieures à 115 degrés Celsius, variant de préférence de 30 degrés Celsius à 100 degrés Celsius, variant plus préférentiellement de 60 degrés Celsius à 90 degrés Celsius pendant une période inférieure à 60 minutes, ou inférieure à 15 minutes, de préférence pendant une période de 8 minutes à 12 minutes.

14. Procédé selon l'une quelconque des revendications précédentes, dans lequel la composition de pérovskite, la deuxième composition et/ou la troisième composition sont imprimées par jet d'encre.
